# EUROPÄISCHE PATENTSCHRIFT

(11) **EP 2 942 848 B1**
(45) Veröffentlichungstag und Bekanntmachung des Hinweises auf die Patenterteilung: **04.12.2024**
(21) Anmeldenummer: 15165212.0
(22) Anmeldetag: 27.04.2015
(51) Int. Cl.: H01S 5/12, H01S 5/22, H01S 5/34

(54) **HALBLEITERLASER SOWIE VERFAHREN ZUR HERSTELLUNG EINES HALBLEITERLASERS UMFASSEND EIN RÜCKKOPPLUNGSELEMENT**
SEMICONDUCTOR LASER AND METHOD FOR MAKING A SEMICONDUCTOR LASER COMPRISING A FEEDBACK ELEMENT
LASER À SEMI-CONDUCTEUR ET PROCÉDÉ DE PRODUCTION D'UN LASER À SEMI-CONDUCTEUR COMPRENANT UN ÉLÉMENT DE RÉTROACTION

(30) Priorität: 05.05.2014 DE 102014106209
(43) Veröffentlichungstag der Anmeldung: 11.11.2015
(73) Patentinhaber: Advanced Photonics Applications GmbH, 97218 Gerbrunn (DE)
(72) Erfinder: Koeth, Johannes, 97218 Gerbrunn (DE); Nähle, Lars, 97342 Obernbreit (DE)
(74) Vertreter: advotec.

(56) Entgegenhaltungen:
- US-A1- 2012 093 187
- CANEDY C L ET AL: "High-power CW performance of 7-stage interband cascade lasers", PROCEEDINGS OF SPIE, S P I E - INTERNATIONAL SOCIETY FOR OPTICAL ENGINEERING, US, vol. 9002, 27 February 2014 (2014-02-27), pages 90021C - 90021C, XP060035221, ISSN: 0277-786X, DOI: 10.1117/12.2039941
- TIBERIO ET AL: "Laterally-Coupled Distributed Feedback laser fabricated with electron beam lithography and chemically assisted ion beam etching", MICROELECTRONIC ENGINEERING, ELSEVIER PUBLISHERS BV., AMSTERDAM, NL, vol. 27, no. 1-4, 1 February 1995 (1995-02-01), pages 67 - 70, XP022353798, ISSN: 0167-9317, DOI: 10.1016/0167-9317(94)00057-2

## Beschreibung

Die vorliegende Erfindung betrifft einen Halbleiterlaser gemäß dem Oberbegriff des Anspruchs 1 sowie ein Verfahren zur Herstellung eines Halbleiterlasers gemäß Anspruch 9.

Bei bekannten Halbleiterlasern und deren Herstellungsverfahren werden im Allgemeinen Mehrschichtstrukturen aus Halbleitermaterialien, Isolatormaterialien sowie gegebenenfalls Metallen durch entsprechende Abscheidungsverfahren und Schichtwachstumsverfahren gebildet und durch im Allgemeinen bekannte Verfahren, wie Lithographie- oder Ätzverfahren, strukturiert. Allen Halbleiterlasern ist dabei gemein, dass sie zumindest eine aktive Region aufweisen, in der stimulierte Emission erfolgt, wodurch die Funktion eines Lasers ermöglicht wird.

Bei der Ausbildung der aktiven Region gibt es im Wesentlichen zwei Unterschiede bei bekannten Halbleiterlasern im Hinblick auf die räumliche Ausbreitung der aktiven Region. Bei Halbleiterlaserdioden beispielsweise ist im Allgemeinen die aktive Region flächig bzw. im gesamten Bereich der Mehrschichtstruktur vorhanden, und eine Lokalisierung der Laserstrahlung wird durch über und/oder unter der aktiven Region angeordnete Elemente, wie beispielsweise Wellenleiter und/oder einen Steg, erreicht, die eine entsprechende räumliche Struktur aufweisen. Bei derartigen Halbleiterlasern ist es zudem bekannt, optische Rückkopplungselemente oberhalb und/oder unterhalb der aktiven Region anzuordnen, die eine Modenselektion der Laserstrahlung ermöglichen, und dadurch im besten Falle die von dem Halbleiterlaser emittierte Laserstrahlung auf eine einzige Lasermode einzugrenzen.

Abgesehen von derartigen Halbleiterlasern sind ebenfalls Strukturen bekannt, bei denen eine räumliche Begrenzung der aktiven Region notwendig oder zumindest sinnvoll ist. Diese Notwendigkeit der räumlichen Begrenzung ist im Allgemeinen durch das Problem der Stromaufweitung verursacht, welches ein Aufweiten eines Pumpstroms innerhalb der aktiven Region bezeichnet, wodurch lediglich eine räumlich weniger lokalisierte und damit ineffiziente Erzeugung von Laserstrahlung erfolgen kann. Um eine derartige Stromaufweitung innerhalb der aktiven Region zu verhindern, werden bei derartigen Halbleiterlasern im Rahmen der Strukturierung der Mehrschichtstruktur in der Regel Materialabtragungen vorgenommen, die in einer Materialabtragsrichtung erfolgen, welche in der Regel senkrecht auf einer Oberfläche eines Substrats des Halbleiterlasers steht, und bei denen zumindest soviel Material bzw. so viele Schichten abgetragen werden, dass auch die aktive Region zumindest bereichsweise entlang der Materialabtragsrichtung vollständig abgetragen und damit senkrecht zur Schichtausbreitungsebene in einer Dimension räumlich begrenzt wird.

Auch bei derartigen Halbleiterlasern sind bereits Strukturierungsversuche unternommen worden, die darauf abzielten, ein optisches Rückkopplungselement möglichst in räumlicher Nähe zur aktiven Region anzuordnen und damit eine optische Rückkopplung sowie eine daraus resultierende Modenselektion der Laserstrahlung in der aktiven Region zu ermöglichen. Bekannt ist beispielsweise aus der US 2006/0056472 A1 sowie aus der Veröffentlichung "High-power CW performance of 7-stage interband cascade lasers", Canedy C. L. et al, Proc. of SPIE Vol. 9002 Seiten 90021C-1 bis 90021C-7 das Vorsehen einer so genannten vertikalen Gitterstruktur (Vertical Grating). Derartige Strukturen haben sich jedoch in mehrerlei Hinsicht als nachteilig erwiesen. Zunächst sind deren Herstellung bzw. die entsprechenden Herstellungsverfahren komplex. Zudem oder gerade deshalb ist auch die prozentuale Ausbeute an Lasern, die die gewünschte Spezifikation der spektralen Einmodigkeit bzw. Monomodigkeit aufweisen, nur sehr gering.

Aus der US 2005/0276298 A1 ist darüber hinaus für unipolare Laser bekannt, eine Vielzahl von Laserkavitäten hintereinander anzuordnen, um durch die Überlagerung der einzelnen Spektren eine Modenselektion zu erreichen. Dabei können auch unterschiedliche Anordnungen von Gitterstrukturen zum Einsatz kommen.

Aus der US 5,982,804 A ist zudem ein DFB-Halbleiterlaser bekannt, der eine aus einem Halbleitermaterial ausgebildete Gitterstruktur aufweist. Die Oberkante der Halbleiter-Gitterstruktur kann dabei auf der Höhe der Oberkante der aktiven Zone des Lasers angeordnet sein.

Aus den Druckschriften US 2001/0036213 A1 und JP S62-295 480 A sind zudem DFB-Laser bekannt, bei denen eine Gitterstrukturschicht im Bereich des Wellenleiterstegs und der daran angrenzenden Materialabtragsbereiche angeordnet ist.

Die Druckschrift US 2012/093187 A1 beschreibt einen besonderen Aufbau der Wellenleiterschicht für eine erhöhte Ausgangsleistung einer Laserdiode, wobei lateral zu einem Stegwellenleiter Metallgitter eine Modenstruktur des Lasers definieren.

Dementsprechend ist es Aufgabe der vorliegenden Erfindung, einen Halbleiterlaser mit einer aktiven Region aufweisend eine Schichtstruktur zur Ausbildung eines Interbandkaskadenlasers sowie ein Verfahren zu dessen Herstellung vorzuschlagen, bei dem bzw. durch das ein Interbandkaskadenlaser bereit gestellt wird, der keine Stromaufweitung durch eine entsprechende räumliche Begrenzung der aktiven Region zeigt und eine effektive Modenselektion des Lasers bzw. der Laserstrahlung mittels eines entsprechenden optischen Rückkopplungselements erlaubt sowie zudem eine möglichst hohe prozentuale Ausbeute an spektral monomodigen Lasern verwirklicht.

Diese Aufgabe wird durch einen Halbleiterlaser gemäß Anspruch 1 sowie durch ein entsprechendes Herstellungsverfahren gemäß Anspruch 9 gelöst. Vorteilhafte Ausführungsformen der vorliegenden Erfindung sind Gegenstand der Unteransprüche.

Der gattungsgemäße Halbleiterlaser weist eine Mehrschichtstruktur, die einen Steg umfasst, und zudem je einen an den Steg seitlich angrenzenden Materialabtragsbereich auf, wobei die Mehrschichtstruktur auf einem Substrat angeordnet ist und wobei durch eine Oberfläche des Substrats eine Schichtausbreitungsebene definiert wird. Der Steg umfasst dabei zumindest eine aktive Region aufweisend eine Schichtstruktur zur Ausbildung eines Interbandkaskadenlasers, wobei die zumindest eine aktive Region durch je einen Übergang zwischen dem Steg und dem Materialabtragungsbereich in einer Dimension der Schichtausbreitungsebene räumlich begrenzt ist. Gattungsgemäß ist vorgesehen, dass zumindest in den Materialabtragsbereichen eine Isolationsschicht und eine darüber angeordnete Gitterstrukturschicht vorgesehen sind. Der Halbleiterlaser ist dadurch gekennzeichnet, dass die Isolationsschicht und die Gitterstrukturschicht so in den Materialabtragungsbereichen angeordnet sind, dass die Gitterstrukturschicht unterhalb, aber nicht mehr als 100 nm unterhalb einer Unterkante der aktiven Region angeordnet ist. Der Abstand soll dabei senkrecht zur Schichtausbreitungsebene bzw. in Wachstumsrichtung oder Abtragungsrichtung gemessen werden und den geringsten Abstand zwischen der Unterkante der aktiven Region und der Gitterstrukturschicht darstellen.

Die optische Kopplung zwischen der Gitterstrukturschicht und dem Laserlicht der aktiven Region ist dadurch besonders effektiv ausgebildet, da die Gitterstrukturschicht erfindungsgemäß Metall, insbesondere Chrom, aufweist. Weiter erfindungsgemäß ist vorgesehen, dass die Gitterstrukturschicht voneinander getrennte, zueinander parallele Stege aus Metall, insbesondere Chrom, aufweist, wobei die Stege der Gitterstrukturschicht senkrecht zur Ausrichtung des Stegs der Mehrschichtstruktur angeordnet sind, so dass eine optische Rückkopplung mit der Laserstrahlung in der aktiven Region erzeugt wird.

Durch die erfindungsgemäße Anordnung der Gitterstrukturschicht wird ermöglicht, dass zumindest ein evaneszenter Anteil der Welle der Laserstrahlung, die sich auch in die Bereiche außerhalb der aktiven Region erstreckt, eine optische Kopplung mit der als Rückkopplungselement ausgebildeten Gitterstrukturschicht erfährt, wodurch sowohl den Anforderungen an das Vermeiden der Stromaufweitung durch die räumliche Begrenzung der aktiven Region als auch den Anforderungen an eine effektive Modenselektion zur Bereitstellung eines monomodigen Halbleiterlasers in besonders vorteilhafter Weise Rechnung getragen wird.

In der vorliegenden Beschreibung soll zur Klarheit folgende sprachliche Definition verwendet werden. Der Begriff "unten" soll im Hinblick auf die vorgeschlagenen Halbleiterlaser und im Hinblick auf das beschriebene Verfahren eine Seite bzw. eine Richtung bezeichnen, die in Bezug auf das Substrat des Halbleiterlasers diesem Substrat zugewandt ist bzw. in Richtung des Substrats weist. Mit anderen Worten ausgedrückt bedeutet dies, dass die Unterkante der aktiven Region als diejenige Begrenzung der aktiven Region zu verstehen ist, die dem Substrat zugewandt ist. Dementsprechend soll auch davon ausgegangen werden, dass die Materialabtragsbereiche durch einen Materialabtrag erzeugt werden, der nach unten entlang einer Richtung bzw. entlang einer Materialabtragsrichtung erfolgt, die im Wesentlichen senkrecht auf einer durch eine Oberfläche des Substrats ausgebildeten Schichtausbreitungsebene verläuft. Die Materialabtragsrichtung verläuft demnach parallel zur Wachstumsrichtung des Schichtwachstums der Mehrschichtstruktur. Dementsprechend soll der Begriff "oben" als eine dem Substrat abgewandte Seite oder Richtung verstanden werden.

Gemäß einer vorteilhaften Ausgestaltung kann vorgesehen sein, dass die Übergänge gerade so tief ausgebildet sind bzw. gerade so viel Material in den Materialabtragsbereichen abgetragen wird, dass die aktive Region in ihrer Stärke oder Schichtdicke gerade so weit abgetragen wird, dass eine möglichst dünne Isolationsschicht zumindest in den Materialabtragsbereichen und eine Gitterstrukturschicht darüber angeordnet wird. Statt dem Aufbringen einer Isolationsschicht ist auch eine natürlich durch Oxidation gebildete Isolationsschicht unter der Gitterstrukturschicht zur Isolation gegenüber der Gitterstrukturschicht geeignet. Bei idealer Ätztiefe bzw. Materialabtrag in den Materialabtragsbereichen kann die Verwendung einer solchen natürlichen oder selbstausbildenden Isolationsschicht vorteilhaft sein.

Besonders vorteilhaft für die Ausbreitung des Laserlichts in der aktiven Region ist es, wenn die Mehrschichtstruktur zumindest eine Wellenleiterschicht umfasst. Besonders vorteilhaft kann es sein, wenn eine erste und eine zweite Wellenleiterschicht vorgesehen sind, wobei jeweils eine Wellenleiterschicht über und eine Wellenleiterschicht unter der aktiven Region angeordnet ist. Für den Fall, dass eine Wellenleiterschicht oberhalb der aktiven Region angeordnet ist, befindet sich diese lediglich im Steg des Halbleiterlasers. Denn durch den Übergang zwischen dem Steg und den Materialabtragsbereichen seitlich des Stegs werden zwangsläufig alle Schichten oberhalb der aktiven Region durch den Materialabtrag bzw. durch den Übergang räumlich in einer Dimension der Schichtausbreitungsebene begrenzt. Dies gilt zumindest für all diejenigen Schichten, die im Rahmen des Herstellungsprozesses vor der Vornahme des Materialabtrags oberhalb der aktiven Region aufgetragen wurden.

Mit anderen Worten ausgedrückt bedeutet dies, dass eine oberhalb der aktiven Region angeordnete Wellenleiterschicht räumlich auf den Steg des Halbleiterlasers begrenzt ist. Gleiches kann, muss jedoch nicht, in gleichem Umfang für eine unter der aktiven Region angeordnete Wellenleiterschicht gegeben sein, da der Übergang zwischen dem Steg und den Materialabtragsbereichen sich zumindest so weit erstreckt, dass die aktive Region räumlich begrenzt wird. Die unterhalb der aktiven Region angeordneten Schichten der Mehrschichtstruktur sind von einer derartigen räumlichen Begrenzung auf den Steg abhängig von der Menge des Materialabtrags betroffen oder auch nicht betroffen.

In der oben bereits genannten Ausführung, in der jedoch die Übergänge gerade so tief sind, dass die aktive Region abgetragen wird, erfolgt keine räumliche Begrenzung einer gegebenenfalls unterhalb der aktiven Region angeordneten Schicht bzw. Wellenleiterschicht.

Weiter ist es besonders vorteilhaft, wenn die Mehrschichtstruktur zumindest eine Mantelschicht aufweist. Diese Mantelschicht kann ebenfalls oberhalb oder unterhalb der aktiven Region, insbesondere oberhalb oder unterhalb einer Wellenleiterschicht, jeweils von der aktiven Region abgewandt, innerhalb der Mehrschichtstruktur angeordnet sein. Bezüglich der räumlichen Eingrenzung der Mantelschicht auf den Bereich des Stegs bzw. auf den Übergang und die Materialabtragsbereiche gilt das oben für die Wellenleiterschicht angeführte Verhältnis in Abhängigkeit der Anordnung der Mantelschicht oberhalb bzw. unterhalb der aktiven Region. Besonders vorteilhaft kann es für den Betrieb des Halbleiterlasers sein, wenn sowohl eine Mantelschicht oberhalb der aktiven Region als auch eine Mantelschicht unterhalb der aktiven Region angeordnet ist.

Sowohl für den Betrieb des Halbleiterlasers als auch für dessen Herstellung hat es sich als besonders wünschenswert erwiesen, wenn die Mehrschichtstruktur in der Schichtreihenfolge spiegelsymmetrisch bezüglich der aktiven Region aufgebaut ist.

Weiter kann jedoch auch vorgesehen sein, dass die Mehrschichtstruktur als oberste Schicht eine hochdotierte obere Kontaktschicht bzw. Capschicht aufweist, mittels der eine elektrische Kontaktierung des Halbleiterlasers erleichtert wird. Bevorzugt grenzt die Capschicht dabei senkrecht zur Schichtausbreitungsebene an eine Mantelschicht an.

Weiter kann der Halbleiterlaser auch so ausgebildet sein, dass die Übergänge in einem dem Substrat zugewandten Abschnitt bzw. Endabschnitt einen Ausläufer aufweisen, wobei der Ausläufer so ausgebildet ist, dass der Winkel zwischen dem Übergang und der Schichtausbreitungsebene zu den an den Übergang angrenzenden Materialabtragungsbereichen hin im Wesentlichen stetig geringer wird.

Es ist weiter vorteilhaft, wenn die Ausläufer im unteren Bereich der aktiven Region angeordnet sind bzw. die Unterkante der aktiven Region im Bereich der Ausläufer der Übergänge liegt. Es können gemäß der allgemein vorteilhaften Anordnung der Gitterstrukturschicht auch die Isolationsschicht und die Gitterstrukturschicht im Bereich der Ausläufer der Übergänge angeordnet sein. Dabei ist die Anordnung der Gitterstrukturschicht und der Isolationsschicht bezogen auf eine Richtung in der Schichtabscheidungsebene zu verstehen. Mit anderen Worten ausgedrückt ist es vorteilhaft, wenn die Gitterstrukturschicht zumindest in den Materialabtragsbereichen angeordnet ist und in die Übergänge, dort insbesondere in die Bereiche der Ausläufer, hineinragt. Senkrecht zur Schichtausbreitungsebene können die Gitterstrukturschicht und die Isolationsschicht jedoch so ausgeführt sein wie oben bereits beschrieben. Die Gitterstrukturschicht kann also höchstens 100 nm unterhalb der aktiven Region bzw. deren Unterkante angeordnet sein. Zudem ist es besonders erwünscht, wenn die Übergänge zwischen dem Steg und den Materialabtragsbereichen zumindest abschnittsweise durch je eine Flanke gebildet werden. Die Flanke entsteht dabei durch den Materialabtrag. Trotzdem sollen die Flanken als spezielle Ausgestaltung des Übergangs betrachtet werden und nicht den Materialabtragsbereichen zugeordnet werden. Mit anderen Worten ausgedrückt sollen die Materialabtragsbereiche dadurch definiert werden, dass diese durch einen gleichmäßigen Materialabtrag, in Abtragsrichtung insbesondere senkrecht zur Schichtausbreitungsebene, erzeugt werden. Dementsprechend sind die oben genannten Ausläufer ebenfalls als Teile der Übergänge bzw. als Abschnitt der Flanken zu verstehen, die zwar auch durch Materialabtrag erzeugt werden, jedoch nur an die Materialabtragsbereiche im Sinne dieser Beschreibung angrenzen.

Besonders vorteilhaft für die Herstellung der Halbleiterlaser und für den Betrieb der Halbleiterlaser ist es, wenn die Flanken als schräge Flanken ausgebildet sind, die zumindest abschnittsweise einen Winkel von 10° bis 90°, insbesondere 70° bis 90°, mit der Schichtausbreitungsebene einschließen. Dabei kann der Winkel der Flanke insbesondere in Abhängigkeit von der jeweils verwendeten aktiven Region gewählt werden, um eine besonders gute Wirkung bzw. eine besonders gute Kopplung des Laserlichts an das Rückkopplungselement zu erreichen.

Weiter ist es ganz besonders wünschenswert, wenn die Isolationsschicht und/oder die Gitterstrukturschicht zumindest teilweise im Bereich der Übergänge und/oder im Bereich der Flanken angeordnet sind und zudem insbesondere im Bereich der Flanken im Wesentlichen parallel zu den Flanken verlaufen. Der Fall, dass die Isolationsschicht auch im Bereich der Flanken angeordnet ist, kann beispielsweise derart realisiert werden, dass zum Aufbringen der Isolationsschicht ein Verfahren gewählt wird, das nicht gerichtet ist bzw. keine Vorzugsrichtung bei der Aufbringung oder Abscheidung aufweist. Damit entsteht dann auch im Bereich der Flanken eine Isolationsschicht, die im Wesentlichen parallel zu den Flanken verläuft. Eine Isolationsschicht im Bereich der Flanken dient beispielsweise zur Passivierung des Halbleiterlasers in diesen Bereichen.

Beim gleichzeitigen Anordnen der Gitterstrukturschicht, zumindest teilweise im Bereich der Flanken und insbesondere im Wesentlichen parallel zu den Flanken, wird in besonders vorteilhafter Weise realisiert, dass die Gitterstrukturschicht einerseits durch die Isolationsschicht elektrisch von der aktiven Region getrennt und dadurch ein ungewolltes Abfließen von Strom durch die Gitterstrukturschicht vermieden wird. Zudem ermöglicht eine Anbringung der Gitterstrukturschicht auch im Bereich der Flanken, dass das Ausgangsniveau der Materialabtragsbereiche, auf denen die Isolationsschicht und die Gitterstrukturschicht aufgebracht werden, bzw. die genaue Tiefe des Materialabtrags in Materialabtragsrichtung weitgehend vernachlässigt werden kann und zugleich die Bedingung erfüllt wird, dass sowohl entlang der Schichtausbreitungsebene als auch entlang der Materialabtragsrichtung die Gitterstrukturschicht so nah an der aktiven Region angeordnet werden kann, dass eine optische Rückkopplung zwischen der Gitterstrukturschicht und der Laserstrahlung in der aktiven Region ermöglicht wird.

Für einen Interbandkaskadenlaser ist der Winkel zwischen der Schichtausbreitungsebene und der Flanke möglichst klein zu wählen. Als derzeit praktikabel und verlässlich herstellbar haben sich dabei Winkel von etwa 70° erwiesen. Es ist jedoch gleichzeitig vorstellbar und wünschenswert, diesen Winkel weiter zu verkleinern. Grundsätzlich ist eine Reduktion des Winkels auf etwa 10° sowohl technisch möglich als auch gewünscht.

Für den Fall, dass die aktive Region eine Schichtstruktur umfasst, die zur Ausbildung eines Quantenkaskadenlasers dient, ist hingegen ein möglichst rechtwinkeliger Übergang zwischen dem Steg und den Übergängen bzw. Flanken wünschenswert. Mit anderen Worten ausgedrückt bedeutet dies, dass für eine solche aktive Region die Flanke bevorzugt einen Winkel von etwa 90° mit der Schichtausbreitungsebene einschließt. Auch hier sind jedoch etwas geringere Winkel noch durchaus vorteilhafter und deutlich einfacher herzustellen bzw. zu erreichen. Dementsprechend können auch Winkel zwischen 80° und 90° für aktive Regionen zur Ausbildung eines Quantenkaskadenlasers vorgesehen werden.

Das erfindungsgemäße Verfahren zur Herstellung eines Halbleiterlasers umfasst die Verfahrensschritte des Anspruchs 9, die jedoch ausdrücklich nicht die Gesamtheit aller Verfahrensschritte abbilden.

Vielmehr sind die wesentlichen Verfahrensschritte wiedergegeben bzw. beansprucht, die zur Erreichung des erfindungsgemäßen Effekts dienen. Eine Vielzahl weiterer Bearbeitungsschritte, wie sie aus Herstellungsverfahren gattungsgemäßer Halbleiterlaser sowie gattungsgemäßer Gitterstrukturschichten bekannt sind, kann rein numerisch den Großteil der gesamten Verfahrensschritte zur Herstellung des Halbleiterlasers darstellen.

Gattungsgemäß ist es jedoch unerlässlich, dass zunächst eine Mehrschichtstruktur auf einem Substrat aufgebracht wird, wobei die Schichten der Mehrschichtstruktur parallel zu einer durch eine Oberfläche des Substrats definierten Schichtausbreitungsebene verlaufen und wobei das Aufbringen der Mehrschichtstruktur zumindest das Erzeugen einer aktiven Region umfassend eine Schichtstruktur zur Ausbildung eines Interbandkaskadenlaser umfasst.

In einem weiteren gattungsgemäßen Verfahrensschritt ist das Abtragen von Material der Mehrschichtstruktur in zumindest zwei voneinander getrennten Materialabtragsbereichen vorgesehen, wobei dadurch der Materialabtrag im Wesentlichen senkrecht zur Schichtausbreitungsebene bzw. in Materialabtragsrichtung erfolgt und dadurch in einem Bereich, in dem kein Materialabtrag erfolgt, nämlich zwischen den Materialabtragsbereichen, ein Steg gebildet wird, der durch je einen Übergang von den Materialabtragsbereichen so getrennt ist, dass zumindest die aktive Region durch die Übergänge in einer Dimension der Schichtausbreitungsebene räumlich eingegrenzt wird.

Daran zumindest mittelbar anschließend erfolgt das Aufbringen von einer Isolationsschicht auf zumindest die Materialabtragsbereiche sowie das anschließende Aufbringen einer Gitterstrukturschicht zumindest im Bereich der Materialabtragsbereiche.

Der erfindungsgemäße Grundgedanke wird bei dem vorliegenden Verfahren unter anderem dadurch realisiert, dass der Verfahrensschritt des Materialabtrags und die Verfahrensschritte des Aufbringens der Isolationsschicht und/oder der Gitterstrukturschicht so aufeinander abgestimmt sind, dass die Gitterstrukturschicht unterhalb, aber nicht mehr als 100 nm unterhalb, einer Unterkante der aktiven Region angeordnet wird.

Weiter ist erfindungsgemäß vorgesehen, dass zur Herstellung der Gitterstrukturschicht ein Metall, insbesondere Chrom, zumindest abgeschieden und strukturiert wird.

Dies geschieht erfindungsgemäß im Rahmen eines Teilverfahrens, welches ein Elektronenstrahllithografieverfahren vorsieht. Dabei wird ein zunächst aufgebrachter Lack belichtet, entwickelt, anschließend das Metall bzw. Chrom abgeschieden, und anschließend werden die Bereiche, in denen der Lack nicht belichtet wurde, abgehoben. So entstehen in zumindest den Bereichen der Gitterstrukturschicht, die zur Kopplung mit dem Laserlicht beitragen, voneinander getrennte Stege des Rückkopplungselements. Diese sind erfindungsgemäß senkrecht zur Ausbreitung des Stegs der Mehrschichtstruktur angeordnet. Weiter weisen die Stege erfindungsgemäß in den voneinander getrennten Bereichen zumindest abschnittsweise eine Periodizität auf. Durch das vorgeschlagene Herstellungsverfahren eines Halbleiterlasers wird erreicht, dass einerseits in der aktiven Region die Stromaufweitung unterbunden wird, was durch den Materialabtrag erreicht wird, der zumindest auch die volle Höhe der aktiven Region umfasst bzw. die aktive Region auf den Steg eingrenzt. Zudem wird durch das erfindungsgemäße Verfahren eine Modenselektion der Laserstrahlung mittels einer beispielsweise als DFB-Struktur ausgebildeten Gitterstrukturschicht so erreicht, dass während des Verfahrens eine höhere Prozesstoleranz bezüglich der Anordnung der Gitterstrukturschicht ermöglicht wird. Dies führt wiederum zu einer höheren prozentualen Ausbeute an monomodigen Halbleiterlasern und folglich zu günstigeren Herstellungskosten.

Mit anderen Worten ausgedrückt bedeutet dies, dass die drei Verfahrensschritte Materialabtrag, Aufbringen der Isolationsschicht und Aufbringen der Gitterstrukturschicht insgesamt im Hinblick auf die Abtragungstiefe bzw. die Schichtstärken der aufgebrachten Isolationsschicht und Gitterstrukturschicht so aufeinander abgestimmt werden können, dass schließlich die Gitterstrukturschicht nicht mehr als 100 nm unter der Unterkante der aktiven Region angeordnet ist. Insgesamt kann also die Genauigkeit bzw. die Unsicherheit in einem der genannten Verfahrensschritte durch die jeweils zwei anderen Verfahrensschritte ausgeglichen werden, so dass im Endeffekt die relative Anordnung der Gitterstrukturschicht bezüglich der Unterkante der aktiven Region erreicht werden kann.

Besonders vorteilhaft für den herzustellenden Halbleiterlaser ist es, wenn dieser zumindest eine Wellenleiterschicht und/oder eine Mantelschicht über bzw. unter der aktiven Region aufweist. Dementsprechend sieht eine vorteilhafte Ausgestaltung des vorgeschlagenen Verfahrens vor, dass das Erzeugen der Mehrschichtstruktur bzw. das Aufbringen der Mehrschichtstruktur das Aufbringen von zumindest einer Wellenleiterschicht und/oder das Aufbringen von zumindest einer Mantelschicht umfasst.

Beispielsweise kann vorgesehen sein, dass jeweils direkt oberhalb und unterhalb der aktiven Region eine Wellenleiterschicht angeordnet ist und jeweils oberhalb der oberen Wellenleiterschicht und unterhalb der unteren Wellenleiterschicht eine Mantelschicht angeordnet ist. In einer bevorzugten Ausgestaltung des Verfahrens werden durch den Materialabtrag in einem dem Substrat zugewandten Abschnitt bzw. Endabschnitt der Übergänge Ausläufer gebildet, wobei die Ausläufer so ausgestaltet sind, dass der Winkel zwischen dem Übergang und der Schichtausbreitungsebene zu den an den Übergang angrenzenden Materialabtragungsbereichen hin im Wesentliche stetig geringer wird.

Zudem kann das vorgeschlagene Verfahren so ausgestaltet sein, dass durch den Materialabtrag die Übergänge zwischen dem Steg und den Materialabtragsbereichen zumindest abschnittsweise in Form je einer Flanke gebildet werden und dass der Materialabtrag insbesondere derart erfolgt, dass die Flanken zumindest abschnittsweise als schräge Flanken ausgebildet werden und einen Winkel von 10° bis 90°, insbesondere zwischen 70° und 90°, mit der Schichtausbreitungsebene des Substrats einschließen. Wie mit Bezug auf die offenbarte Vorrichtung bzw. den offenbarten Halbleiterlaser bereits ausgeführt, kann die Wahl des Winkels zwischen einer Flanke zur Bildung eines Übergangs zwischen dem Steg und einem Materialabtragsbereich von der Form bzw. Funktionsweise der aktiven Region abhängen, wobei insbesondere bei einer aktiven Region zur Ausbildung eines Interbandkaskadenlasers möglichst geringe Winkel, insbesondere Winkel zwischen 10° und 70°, vorgesehen bzw. wünschenswert sind und bei einer aktiven Region, die ein solches Schichtsystem aufweist, das die Ausbildung eines Quantenkaskadenlasers ermöglicht, möglichst Flanken mit einem rechten Winkel zur Schichtausbreitungsebene hergestellt werden, nämlich Flanken mit einem Winkel zwischen etwa 80° und 90° bezüglich der Schichtausbreitungsebene des Substrats.

In einer weiteren besonders vorteilhaften Ausführung des vorgeschlagenen Verfahrens werden die Isolationsschicht und/oder die Gitterstrukturschicht beim Aufbringen so angeordnet bzw. das Aufbringen der Schichten so gesteuert, dass die Isolationsschicht und/oder die Gitterstrukturschicht zumindest teilweise im Bereich der Übergänge und/oder im Bereich der Flanken angeordnet sind und im Bereich der Flanken im Wesentlichen parallel zu den Flanken verlaufen.

Dadurch werden eine Passivierung mittels der Isolationsschicht und eine elektrische Isolierung der Übergänge bzw. der Flanken erreicht.

Zudem kann eine besonders gute und effektive Kopplung zwischen der Laserstrahlung in der aktiven Region und der Gitterstrukturschicht erreicht werden.

Im Weiteren werden einzelne vorteilhafte Ausgestaltungen der erfindungsgemäßen Halbleiterlaser und des erfindungsgemäßen Verfahrens anhand der lediglich schematischen Zeichnungen beispielhaft erläutert.

Es zeigen:
- Fig. 1A bis 1C: beispielhafte Stationen des Herstellungsverfahrens eines erfindungsgemäßen Halbleiterlasers sowie einen im Wesentlichen fertig gestellten Halbleiterlaser gemäß der Erfindung;
- Fig. 2: einen Schnitt durch einen erfindungsgemäßen Halbleiterlaser in einer ersten alternativen Ausführung;
- Fig. 3: einen Schnitt durch einen erfindungsgemäßen Halbleiterlaser in einer zweiten alternativen Ausführung;
- Fig. 4: einen Schnitt durch einen erfindungsgemäßen Halbleiterlaser in einer dritten alternativen Ausführung;
- Fig. 5: einen Ausschnitt aus einem Schnitt durch einen erfindungsgemäßen Halbleiterlaser in einer vierten alternativen Ausführung;

- Fig. 6: einen Ausschnitt aus einem Schnitt durch einen erfindungsgemäßen Halbleiterlaser in einer fünften alternativen Ausgestaltung;
- Fig. 7: einen Ausschnitt aus einem Schnitt durch ein Beispiel eines Halbleiterlaser zum besseren Verständnis der Erfindung.

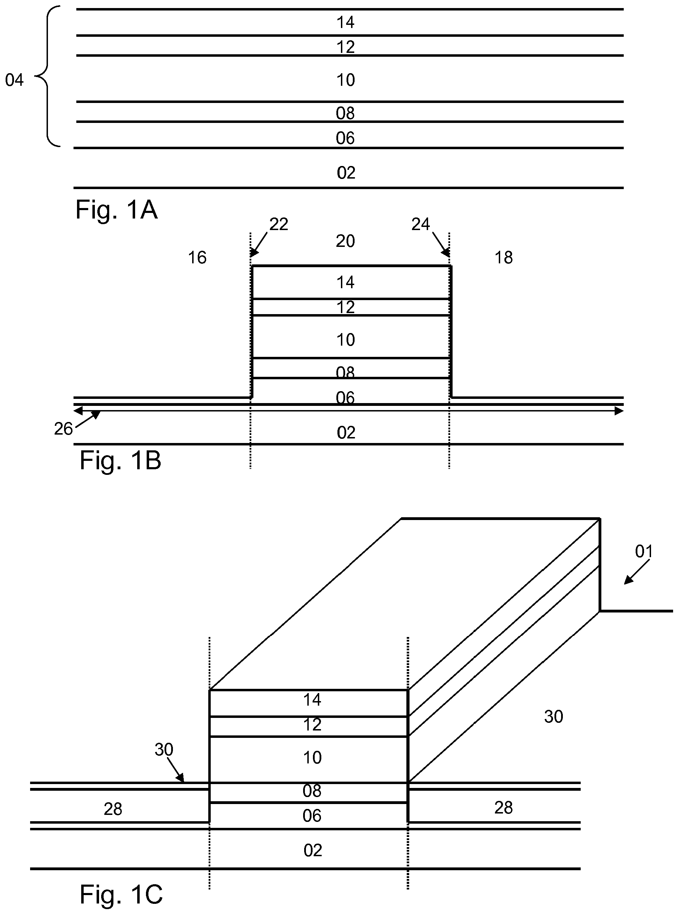

Fig. 1A zeigt ein Prozess- bzw. Verfahrensstadium während des erfindungsgemäßen Verfahrens zur Herstellung eines erfindungsgemäßen Halbleiterlasers 01. In Fig. 1A ist auf einem Substrat 02 bereits eine Mehrschichtstruktur 04 durch im Allgemeinen bekannte Verfahrensschritte bzw. Epitaxieschritte aufgebracht worden. Die Mehrschichtstruktur 04 umfasst dabei in der Reihenfolge der aufgebrachten Schichten bzw. von unten nach oben eine erste Mantelschicht 06 bzw. eine untere Mantelschicht 06, eine erste bzw. untere Wellenleiterschicht 08, eine aktive Region 10 sowie eine zweite bzw. obere Wellenleiterschicht 12 und schließlich eine zweite bzw. obere Mantelschicht 14. Die aktive Region 10 kann dabei selbst wiederum aus einer Vielzahl einzelner Schichten bestehen, die unter anderem beispielsweise Injektorschichten umfassen können.

Fig. 1B zeigt ein Prozess- bzw. Verfahrensstadium, welches ein Zwischenprodukt zur Herstellung des erfindungsgemäßen Halbleiters nach dem Vornehmen des Materialabtrags darstellt. Wie in Fig. 1B zu sehen ist, wurden im Vergleich zur Fig. 1A in den Materialabtragsbereichen 16, 18 die zuvor aufgebrachten Schichten bis auf die untere Mantelschicht 06 vollständig abgetragen und die untere Mantelschicht 06 ebenfalls teilsweise abgetragen. Dadurch wird zwischen den Materialabtragsbereichen 16 und 18 der Steg 20 ausgebildet, der durch die Übergänge 22 und 24 so von den Materialabtragsbereichen getrennt ist, dass die aktive Region 10 in einer Raumrichtung der Schichtausbreitungsebene 26 räumlich begrenzt ist und dadurch die Stromaufweitung innerhalb der aktiven Region 10 überwunden wird.

In der Fig. 1B wird die vorliegende Erfindung im Folgenden so beschrieben, dass im Rahmen des Materialabtrags nicht alle Schichten der Mehrschichtstruktur vollständig abgetragen werden, sondern die jeweils unterste Schicht bzw. an das Substrat grenzende Schicht zum Teil erhalten bleibt. Dies erfolgt jedoch nur zu Zwecken der Darstellung. Zur Ausführung der Erfindung kann jedoch gleichermaßen vorgesehen sein, dass alle Schichten der Mehrschichtstruktur durch den Materialabtrag vollständig abgetragen werden und damit nach dem Materialabtrag in den Materialabtragsbereichen 16 und18 das Substrat bzw. eine Substratoberfläche freiliegt bzw. freigelegt wird. Andererseits kann jedoch auch vorgesehen sein, dass der Materialabtrag nur so weit erfolgt, bis zumindest die aktive Region 10 räumlich eingegrenzt ist und eine unter der aktiven Region angeordnete Schicht bzw. angeordnete Schichten vom Materialabtrag unberührt bleibt bzw. bleiben oder nur teilweise abgetragen wird bzw. werden. Ebenfalls zeigen alle Figuren einen die Schichtreihenfolge betreffenden symmetrischen Aufbau der Mehrschichtstruktur 04 bezüglich der aktiven Region 10. Dies ist eine vorteilhafte Ausführung, wobei jedoch auch andere, davon abweichende Schichtabfolgen vorteilhaft vorgesehen sein können.

Die Fig. 1C zeigt eine schematisierte Perspektivansicht eines Halbleiterlasers 01 nach Abschluss des erfindungsgemäßen Verfahrens. Gegenüber dem Prozess- bzw. Verfahrenszustand der Fig. 1B sind in der Fig. 1C zumindest in den Materialabtragsbereichen 16 und 18 eine Isolationsschicht 28 und eine Gitterstrukturschicht 30 aufgebracht bzw. erzeugt worden. Wie aus der Fig. 1C ersichtlich, ist dabei die Oberkante der Gitterstrukturschicht 30 im Wesentlichen auf gleicher Höhe mit der Unterkante der aktiven Region 10. Dadurch wird eine besonders effektive optische Kopplung zwischen der Laserstrahlung in der aktiven Region 10 und der Gitterstrukturschicht 30 ermöglicht, was dementsprechend zu einer sehr genauen Modenselektion des Halbleiterlasers 01 führt.

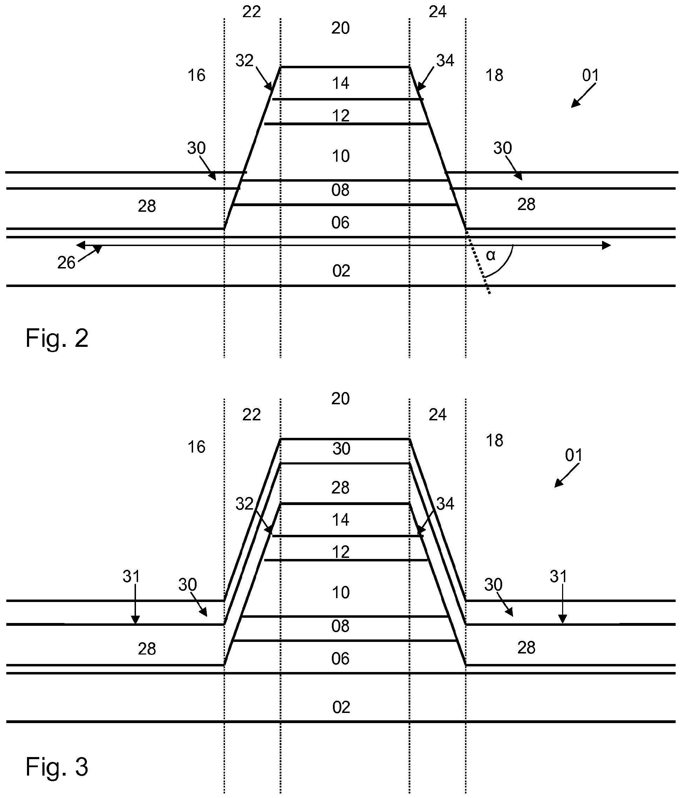

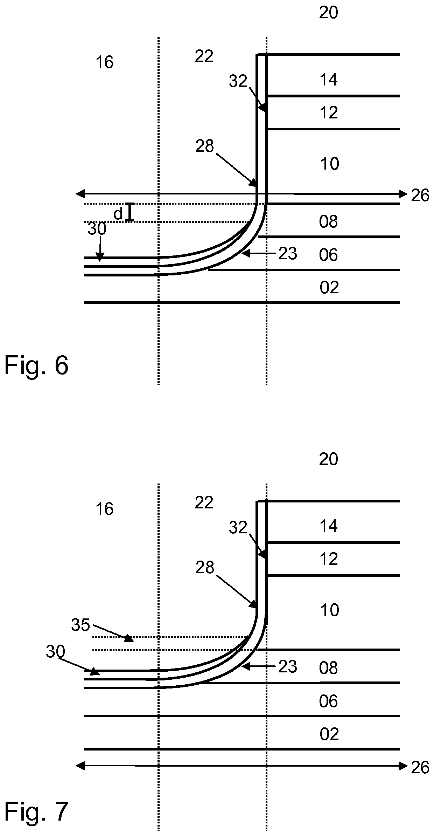

Wie jedoch aus der weiteren Beschreibung, insbesondere zu der Fig. 2 und der Fig. 6 hervorgeht, ist diese Anordnung der Gitterstrukturschicht 30 bezüglich der aktiven Region 10 der Fig. 1C nicht die einzig mögliche oder sinnvolle Ausgestaltung. Allgemein kann die Gitterstrukturschicht entweder so angeordnet werden, dass ihre Position zur aktiven Region senkrecht zur Schichtausbreitungsebene entweder ein Überschneiden der Gitterstrukturschicht 30 und der aktiven Region 10 ermöglicht oder die Gitterstrukturschicht 30 zumindest nicht mehr als 100 nm unterhalb der aktiven Region 10 bzw. deren Unterkante angeordnet ist.

Wie aus Fig. 1C leicht ersichtlich, ist die entsprechende Anordnung der Gitterstrukturschicht bezüglich der aktiven Region in verhältnismäßig einfacher Weise erreichbar bzw. einstellbar, da diese durch die nacheinander folgenden Verfahrensschritte des Materialsabtrags, des Aufbringens der Isolationsschicht 28 und der daran anschließenden Aufbringung der Gitterstrukturschicht 30 eingestellt werden kann. Mit anderen Worten ausgedrückt bedeutet dies, dass die Schichtdicke der Isolationsschicht 28 oder der Gitterstrukturschicht 30, je nachdem, wie viel Material durch den Materialabtrag entfernt wurde, eingestellt werden kann und somit die entsprechende bzw. beanspruchte Anordnung der Gitterstrukturschicht zumindest auf der Höhe der Unterkante der aktiven Region 10 einfach erreicht werden kann. Anstatt einer zusätzlich aufgebrachten Isolationsschicht 28 kann die Isolationsschicht auch durch Oxidation der mittels des Materialabtrags freigelegten Oberflächen erzeugt werden. Erzeugt bedeutet dabei vielmehr, dass sich die Isolationsschicht 28 bei Sauerstoffeinwirkung selbst bzw. natürlich ausbildet. Fig. 2 zeigt einen Schnitt durch einen erfindungsgemäßen Halbleiterlaser. Neben den Materialabtragsbereichen 16 und 18 sowie dem Steg 20 zeigt die Fig. 2 je einen Übergang 22 bzw. 24 zwischen dem Steg und den jeweiligen Materialabtragungsbereichen 16 und 18, wobei der Übergang 22 und 24 durch die Flanken 32 und 34 gebildet wird, wobei die Flanken 32, 34 jeweils einen Winkel von ca. 80° mit der Schichtausbreitungsebene 26 einschließen, wie in Fig. 2 durch die Skizzierung des Winkels α angedeutet.

Wie aus Fig. 2 ebenfalls ersichtlich, sind in der dort dargestellten Ausführung des Halbleiterlasers 01 die Isolationsschicht 28 sowie die Strukturschicht 30 nicht ausschließlich im Bereich der Materialabtragsbereiche 16 und 18, sondern auch im Bereich der Übergänge 22 und 24 angeordnet, wobei jedoch im Bereich der Übergänge 22 und 24 die Gitterstrukturschicht 30 nach wie vor im Wesentlichen parallel zu der Schichtausbreitungsebene 26 verläuft. Ebenfalls in Fig. 2 dargestellt ist die vorteilhafte Ausführungsform, nach der die Gitterstrukturschicht 30 bzw. deren Oberkante nicht plan mit der Unterkante der aktiven Region 10 abschließt, sondern auch oberhalb der Unterkante der aktiven Region verläuft bzw. angeordnet ist. Dadurch kann die Kopplung zwischen der Laserstrahlung der aktiven Region 10 und der Gitterstrukturschicht 30 gegenüber der Darstellung der Fig. 1C weiter verbessert werden.

Fig. 3 zeigt eine Abwandlung des Halbleiterlasers 01 gegenüber der Fig. 2, die dadurch entsteht, dass die Isolationsschicht 28 nicht nur im Bereich der Materialabtragsbereiche 16 und 18, sondern auch im gesamten Bereich der Übergänge 22 und 24 und im Bereich des Stegs 20 angeordnet ist. Dabei kann vorgesehen sein, dass das Verfahren zur Herstellung des Halbleiterlasers 01 vor dem Aufbringen der Isolationsschicht 28 zunächst einen Verfahrensschritt vorsieht, mittels dessen auf der gesamten freiliegenden Oberfläche nach dem Materialabtrag eine weitere Entfernung einer sich natürlich ausbildenden bzw. natürlich ausgebildeten Passivierungsschicht bzw. Oxidschicht erfolgt und anschließend die Isolationsschicht 28 flächendeckend über alle Bereiche aufgebracht wird. Wie in der Fig. 3 dargestellt, ist auch die Gitterstrukturschicht 30 im gesamten Bereich der Übergänge 22 und 24 und zudem im Wesentlichen parallel zu den Flanken 32 und 34 vorgesehen bzw. angeordnet. Auch wenn dadurch die Gitterstrukturschicht von der aktiven Region 10 durch die Isolationsschicht 28 getrennt wird, führt die in der Fig. 3 dargestellte Ausgestaltung des Halbleiterlasers 01 jedoch dazu, dass die Gitterstrukturschicht 30, die mit ihrer Unterkante 31 unter der Unterkante der aktiven Region 10 liegt, sich in Richtung der Materialabtragsrichtung über die volle Höhe der aktiven Region erstreckt und somit eine besonders effektive optische Kopplung zwischen der Laserstrahlung in der aktiven Region 10 und der Gitterstrukturschicht erreicht werden kann.

Aus der Darstellung der Fig. 3 geht ein weiterer wesentlicher Vorteil der vorliegenden Ausgestaltung deutlich hervor. Durch die Anordnung der Gitterstrukturschicht im Bereich der Flanken 32, 34 wird ab einer bestimmten Materialabtragstiefe die erfindungsgemäße relative Anordnung zwischen Gitterstrukturschicht 30 und aktiver Region 10 automatisch erreicht. Mit anderen Worten ausgedrückt bedeutet dies, dass selbst bei einem entsprechend größeren Materialabtrag in den Materialabtragsbereichen 16 und 18 und entsprechend tiefer liegenden Materialabtragsbereichen 16, 18 durch die Anordnung der Isolationsschicht und der Gitterstrukturschicht auch im Bereich der Flanken 32, 34 die gewünschte Anordnung der Gitterstrukturschicht 30 bezüglich der aktiven Region 10 zwangsläufig erreicht wird, da durch die Teile der Gitterstrukturschicht 30 im Bereich der Flanken 32, 34 die Anordnung der Gitterstrukturschicht 30 von nicht mehr als 100 nm unterhalb der aktiven Region, wahlweise auf dem Niveau der Unterkante der aktiven Region 10 oder darüber immer erreicht wird, sobald sich die Tiefe des Materialabtrags zuzüglich der Stärke der Isolationsschicht 28 auf zumindest 100 nm unterhalb der Unterkante der aktiven Region beläuft. Dies bedeutet aber gerade, dass bei einer Anordnung der Gitterstrukturschicht 30 im Bereich der Übergänge 22, 24 oder Flanken 32, 34 die Abtragstiefe der Materialabtragsbereiche vernachlässigt werden kann, was eine deutlich vereinfachte Herstellung der Halbleiterlaser ermöglicht.

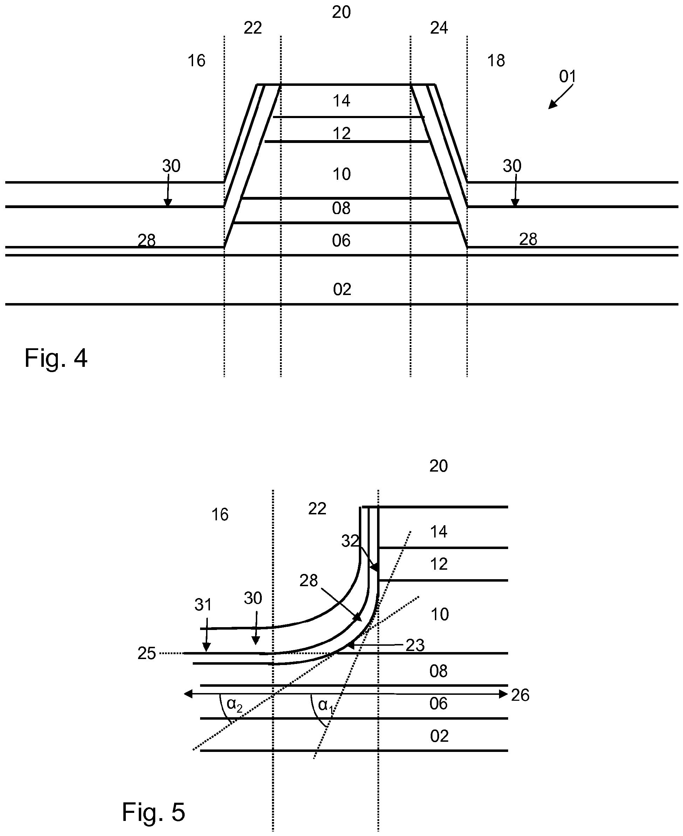

Die Fig. 4 zeigt eine Abwandlung gegenüber der Fig. 3, bei der das Aufbringen der Isolationsschicht 28 sowie der Gitterstrukturschicht 30 im Bereich der oberen Mantelschicht 14 bzw. über die Breite des Stegs 20 wieder entfernt wurde. Diese Entfernung kann vorgenommen werden, um auf der Mantelschicht 14 eine in Fig. 4 nicht dargestellte hochdotierte obere Kontaktschicht bzw. Capschicht freizulegen.

Fig. 5 zeigt einen Ausschnitt aus einem Schnitt eines erfindungsgemäßen Halbleiterlasers 01. Dabei ist der Übergang 22 im oberen Abschnitt als Flanke 32 ausgebildet. In dem dem Substrat 02 zugewandten Abschnitt des Übergangs 22 weist dieser einen Ausläufer 23 auf. Wie durch die Winkel α₁ und α₂ angedeutet, wird der Winkel zwischen dem Übergang und der Schichtausbreitungsebene 26 zu dem an den Übergang angrenzenden Materialabtragsbereich 16 hin seitlich stetig geringer. Stetig ist hier jedoch nicht im streng mathematischen Sinn zu verstehen. Mit anderen Worten ausgedrückt ist der Ausläufer 23 so ausgestaltet, dass der Übergang durch einen abgerundeten Bereich in den Materialabtragsbereich 16 übergeht. Dabei ist der Materialabtrag in der Fig. 5 gerade so tief erfolgt, dass der Materialabtragsbereich 16 minimal unterhalb der Unterkante der aktiven Region angeordnet ist. Die Isolationsschicht 28 ist entsprechend so ausgebildet, dass die Unterkante 31 der Gitterstrukturschicht und die Unterkante der aktiven Region 10 auf einem Niveau liegen, wie durch die waagrechte Punktlinie 25 angedeutet.

In Fig. 5 ist zu erkennen, dass die Isolationsschicht 28 und die Gitterstrukturschicht 30 in dem Materialabtragsbereich 16, im Bereich des Ausläufers 23 des Übergangs 22 sowie im Bereich der Flanke 32 des Übergangs 22 angeordnet sind.

Die Fig. 6 zeigt eine Abwandlung der Fig. 5. Auch in der Fig. 6 wird der Übergang 22 aus einer Flanke 32 im oberen Bereich des Übergangs 22 und durch einen Ausläufer 23 in einem dem Substrat 02 zugewandten Abschnitt des Übergangs 22 gebildet. Im Gegensatz zur Fig. 5 ist jedoch in der Fig. 6 mehr Material in dem Materialabtragungsbereich 16 abgetragen worden. Die Gitterstrukturschicht 30 ist auf der Isolationsschicht 28 aufgebracht. Die Isolationsschicht 28 ist jedoch nur so stark bzw. dick, dass die Gitterstrukturschicht 30 unterhalb der Unterkante der aktiven Region 10 angeordnet ist. Der Abstand zwischen der Unterkante der aktiven Region 10 und der Gitterstrukturschicht 30 senkrecht zur Schichtausbreitungsebene 26 ist durch die Distanz d skizziert. Dabei ist es für eine Kopplung zwischen der Laserstrahlung in der aktiven Region 10 und der Gitterstrukturschicht 30 notwendig, dass die Distanz d nicht größer ist als 100 nm.

In Fig. 7 ist weiter ein Beispiel zum besseren Verständnis der Erfindung dargestellt, bei der im Vergleich zur Fig. 6 ein geringerer bzw. weniger tiefer Materialabtrag im Materialabtragsbereich 16 erfolgt ist. Dementsprechend sind die Isolationsschicht 28 und die Gitterstrukturschicht 30 senkrecht zur Schichtausbreitungsebene 26 höher angeordnet als in Fig. 6. Wie durch die punktierten waagrechten Linien in Fig. 7 angedeutet wird, besteht eine Überlappung 35 zwischen der Unterkante der aktiven Region 10 und der Gitterstrukturschicht 30. Mit anderen Worten ausgedrückt bedeutet dies, dass die Gitterstrukturschicht auf der Höhe der Unterkante der aktiven Region 10 und darüber im Bereich des Ausläufers 23 angeordnet ist. Diese Anordnung erlaubt ebenfalls eine effektive Kopplung des Laserlichts in der aktiven Region 10 an die Gitterstrukturschicht 30, was eine effektive Modenselektion zur Folge hat.

## Patentansprüche

1. Halbleiterlaser (01) aufweisend
eine Mehrschichtstruktur (04) umfassend einen Steg (20) und je einen an den Steg (20) seitlich angrenzenden Materialabtragsbereich (16, 18), wobei die Mehrschichtstruktur (04) auf einem Substrat (02) angeordnet ist und wobei durch eine Oberfläche des Substrats (02) eine Schichtausbreitungsebene (26) definiert wird, der Steg (20) zumindest eine aktive Region (10) aufweist und zumindest die aktive Region (10) durch je einen Übergang (22, 24) zwischen dem Steg (20) und den Materialabtragsbereichen (16, 18) in einer Dimension der Schichtausbreitungsebene (26) räumlich begrenzt ist, wobei die aktive Region (10) eine Schichtstruktur zur Ausbildung eines Interbandkaskadenlasers aufweist, wobei zumindest in den Materialabtragsbereichen (16, 18) eine Isolationsschicht (28) und eine darüber angeordnete Gitterstrukturschicht (30) vorgesehen sind,
wobei die Isolationsschicht (28) und die Gitterstrukturschicht (30) so in den Materialabtragsbereichen (16, 18) angeordnet sind, dass die Gitterstrukturschicht (30) unterhalb, aber nicht mehr als 100 nm unterhalb, einer Unterkante der aktiven Region (10) angeordnet ist, wobei die Gitterstrukturschicht (30) ein Metall aufweist und durch zumindest abschnittsweise periodische Gitterstege gebildet wird, wobei die Gitterstrukturschicht (30) voneinander getrennte, zueinander parallele Gitterstege aus dem Metall aufweist, wobei die Gitterstege der Gitterstrukturschicht (30) senkrecht zur Ausrichtung des Stegs (20) der Mehrschichtstruktur (04) angeordnet sind, so dass eine optische Rückkopplung mit einer Laserstrahlung in der aktiven Region (10) erzeugt wird.

2. Halbleiterlaser (01) nach Anspruch 1,
**dadurch gekennzeichnet,**
**dass** die Mehrschichtstruktur (04) zumindest eine Wellenleiterschicht (08, 12) aufweist.

3. Halbleiterlaser (01) nach einem der Ansprüche 1 oder 2,
**dadurch gekennzeichnet,**
**dass** die Mehrschichtstruktur (04) zumindest eine Mantelschicht (06,14) aufweist.

4. Halbleiterlaser (01) nach Anspruch 3,
**dadurch gekennzeichnet,**
**dass** senkrecht zur Schichtausbreitungsebene (26) an eine Mantelschicht (14) eine hochdotierte obere Kontaktschicht angrenzt.

5. Halbleiterlaser (01) nach einem der Ansprüche 1 bis 4,
**dadurch gekennzeichnet,**
**dass** die Übergänge (22, 24) in je einem dem Substrat (02) zugewandten Abschnitt einen Ausläufer (23) aufweisen, wobei durch den Ausläufer (23) der Winkel zwischen dem Übergang (22) und der Schichtausbreitungsebene (26) zu dem an den Übergang (22) angrenzenden Materialabtragungsbereich (16) hin stetig geringer wird.

6. Halbleiterlaser (01) nach einem der Ansprüche 1 bis 5,
**dadurch gekennzeichnet,**
**dass** die Übergänge (22, 24) zwischen dem Steg (20) und den Materialabtragsbereichen (16, 18) zumindest abschnittsweise durch je eine Flanke (32, 34) gebildet werden.

7. Halbleiterlaser (01) nach Anspruch 6,
**dadurch gekennzeichnet,**
**dass** die Flanken (32, 34) zumindest abschnittsweise durch eine schräge Flanke gebildet werden und einen Winkel von 10° - 90°, insbesondere von 70° - 90°, mit der Schichtausbreitungsebene (26) einschließen.

8. Halbleiterlaser (01) nach einem der Ansprüche 1 bis 7,
**dadurch gekennzeichnet,**
**dass** die Isolationsschicht (28) und/oder die Gitterstrukturschicht (30) zumindest teilweise im Bereich der Übergänge (22, 24) und/oder im Bereich der Flanken (32, 34) angeordnet sind.

9. Verfahren zur Herstellung eines Halbleiterlasers (01) umfassend die Verfahrensschritte:
- Aufbringen einer Mehrschichtstruktur (04) auf einem Substrat (02), wobei die Schichten der Mehrschichtstruktur (04) parallel zu einer durch eine Oberfläche des Substrats (02) definierten Schichtausbreitungsebene (26) verlaufen und wobei das Aufbringen der Mehrschichtstruktur (04) zumindest das Erzeugen einer aktiven Region (10) mit einer Schichtstruktur zur Ausbildung eines Interbandkaskadenlasers umfasst;
- Abtragen von Material der Mehrschichtstruktur (04) in zwei voneinander getrennten Materialabtragsbereichen (16, 18), wobei der Materialabtrag im Wesentlichen senkrecht zur Schichtausbreitungsebene (26) erfolgt und dadurch ein Steg (20) gebildet wird, der durch je einen Übergang (22, 24) von den Materialabtragsbereichen (16, 18) so getrennt ist, dass zumindest die aktive Region (10) durch die Übergänge (22, 24) in einer Dimension der Schichtausbreitungsebene (26) räumlich eingegrenzt wird
- Erzeugen von einer Isolationsschicht (28) auf zumindest den Materialabtragsbereichen (16, 18);
- Aufbringen von einer Gitterstrukturschicht (30) zumindest im Bereich der Materialabtragsbereiche (16, 18), wobei der Materialabtrag und das Aufbringen der Isolationsschicht (28) und/oder der Gitterstrukturschicht (30) so aufeinander abgestimmt sind, dass die Gitterstrukturschicht (30) unterhalb, aber nicht mehr als 100 nm unterhalb, einer Unterkante der aktiven Region (10) angeordnet wird, wobei zur Herstellung der Gitterstrukturschicht ein Metall zumindest abgeschieden und strukturiert wird, so dass in zumindest den Bereichen der Gitterstrukturschicht (30), die zur Kopplung mit dem Laserlicht beitragen, voneinander getrennte Gitterstege aus Metall geformt werden, wobei die Gitterstege senkrecht zur Ausbildung des Stegs (20) der Mehrfachschichtstruktur (04) angeordnet sind und in voneinander getrennten Bereichen zumindest abschnittsweise eine Periodizität aufweisen.

10. Verfahren nach Anspruch 9,
**dadurch gekennzeichnet,**
**dass** das Aufbringen der Mehrschichtstruktur (04) das Aufbringen von zumindest einer Wellenleiterschicht (08, 12) und/oder das Aufbringen von zumindest einer Mantelschicht (06,14) umfasst.

11. Verfahren nach einem der Ansprüche 9 oder 10,
**dadurch gekennzeichnet,**
**dass** durch den Materialabtrag in einem dem Substrat zugewandten Abschnitt der Übergänge (22, 24) ein Ausläufer gebildet wird, wobei der Ausläufer so gebildet wird, dass der Winkel zwischen dem Übergang (22) und der Schichtausbreitungsebene (26) zu dem an den Übergang angrenzenden Materialabtragungsbereich (16) hin stetig geringer wird.

12. Verfahren nach einem der Ansprüche 9 bis 11,
**dadurch gekennzeichnet,**
**dass** durch den Materialabtrag die Übergänge (22, 24) zwischen dem Steg (20) und den Materialabtragsbereichen (16, 18) zumindest abschnittsweise in Form je einer Flanke (32, 34) gebildet werden und insbesondere, dass der Materialabtrag derart erfolgt, dass die Flanken (32, 34) zumindest abschnittsweise als schräge Flanken ausgebildet sind und einen Winkel von 10° - 90°, insbesondere von 70° - 90°, mit der Schichtausbreitungsebene (26) des Substrats (02) einschließen.

13. Verfahren nach einem der Ansprüche 9 bis 12,
**dadurch gekennzeichnet,**
**dass** die Isolationsschicht (28) und/oder die Gitterstrukturschicht (30) zumindest teilweise im Bereich der Übergange (22, 24) und/oder im Bereich der Flanken (32, 34) angeordnet sind.

## Claims

1. A semiconductor laser (01) having
a multilayer structure (04) comprising a ridge (20) and two material removal areas (16, 18) adjacent to the ridge (20) on either side, the multilayer structure (04) being arranged on a substrate (02) and a layer expansion plane (26) being defined by a surface of the substrate (02), the ridge (20) having at least one active region (10) and at least the active region (10) being spatially limited by passages (22, 24) between the ridge (20) and the material removal areas (16, 18) in one dimension of the layer expansion plane (26), the active region (10) having a layer structure for forming an interband cascade laser,
wherein, at least in the material removal areas (16, 18), an insulation layer (28) and a superimposed grating structure layer (30) are provided, the insulation layer (28) and the grating structure layer (30) being arranged in the material removal areas (16, 18) in such a manner that the grating structure layer (30) is arranged below, but not more than 100 nm below, a bottom edge of the active region (10), the grating structure layer (30) comprising a metal and being formed by grating webs that are periodic at least in sections, the grating structure layer (30) having separate parallel webs made of the metal, said grating webs of the grating structure layer (30) being arranged perpendicularly to the orientation of the ridge (20) of the multilayer structure (04) so that an optical feedback with a laser radiation in the active region (10) is produced.

2. The semiconductor laser (01) according to claim 1,
**characterized in that**
the multilayer structure (04) has at least one waveguide layer (08, 12).

3. The semiconductor laser (01) according to any one of claims 1 or 2, **characterized in that**
the multilayer structure (04) has at least one cladding layer (06, 14).

4. The semiconductor laser (01) according to claim 3,
**characterized in that**
perpendicularly to the layer expansion plane (26), a highly doped upper contact layer is adjacent to a cladding layer (14).

5. The semiconductor laser (01) according to any one of claims 1 to 4, **characterized in that**
the passages (22, 24) each have an extension (23) in a section that faces the substrate (02), the angle between the passage (22) and the layer expansion plane (26) becoming continuously smaller toward the material removal area (16) adjacent to the passage (22) by way of the extension (23).

6. The semiconductor laser (01) according to any one of claims 1 to 5, **characterized in that**
at least in sections, the passages (22, 24) between the ridge (20) and the material removal areas (16, 18) are each formed by a flank (32, 34).

7. The semiconductor laser (01) according to claim 6,
**characterized in that**
at least in sections, the flanks (32, 34) are formed by an inclined flank and form an angle of 10° - 90°, in particular of 70° - 90°, with the layer expansion plane (26).

8. The semiconductor laser (01) according to any one of claims 1 to 7, **characterized in that**
the insulation layer (28) and/or the grating structure layer (30) are arranged at least in part in the area of the passages (22, 24) and/or in the area of the flanks (32, 34).

9. A method for producing a semiconductor laser (01) comprising the method steps of:
- applying a multilayer structure (04) onto a substrate (02), the layers of the multilayer structure (04) running parallel to a layer expansion plane (26) defined by a surface of the substrate (02) and the application of the multilayer structure (04) comprising at least the production of an active region (10) having a layer structure for forming an interband cascade laser;
- removing material of the multilayer structure (04) in two separate material removal areas (16, 18), the material being removed substantially perpendicularly to the layer expansion plane (26) and a ridge (20) thus being formed that is separated from the material removal areas (16, 18) by passages (22, 24) in such a manner that at least the active region (10) is spatially limited by the passages (22, 24) in one dimension of the layer expansion plane (26);
- producing an insulation layer (28) at least on the material removal areas (16, 18);
- applying a grating structure layer (30) at least in the area of the material removal areas (16, 18), the removal of material and the application of the insulation layer (28) and/or of the grating structure layer (30) being coordinated in such a manner that the grating structure layer (30) is arranged below, but not more than 100 nm below, a bottom edge of the active region (10), wherein a metal is at least deposited and structured so as to produce the grating structure layer, such that, at least in the areas of the grating structure layer (30) that aid coupling with the laser light, separate grating webs made of metal are formed, said grating webs being arranged perpendicularly to the expansion of the ridge (20) of the multilayer structure (04) and, at least in sections, exhibiting periodicity in separate areas.

10. The method according to claim 9,
**characterized in that**
the application of the multilayer structure (04) comprises the application of at least one waveguide layer (08, 12) and/or the application of at least one cladding layer (06, 14).

11. The method according to any one of claims 9 or 10, **characterized in that**
by removing the material, an extension is formed in a section of the passages (22, 24) that faces the substrate, the extension being formed in such a manner that the angle between the passage (22) and the layer expansion plane (26) becomes continuously smaller toward the material removal area (16) adjacent to the passage.

12. The method according to any one of claims 9 to 11, **characterized in that**
by removing the material, the passages (22, 24) between the ridge (20) and the material removal areas (16, 18) are each formed, at least in sections, in the shape of a flank (32, 34) and, in particular, that the material is removed in such a manner that the flanks (32, 34) are formed, at least in sections, as inclined flanks and form an angle of 10° - 90°, in particular of 70° - 90°, with the layer expansion plane (26) of the substrate (02).

13. The method according to any one of claims 9 to 12, **characterized in that**
the insulation layer (28) and/or the grating structure layer (30) are arranged at least in part in the area of the passages (22,24) and/or in the area of the flanks (32, 34).

## Revendications

1. Laser (01) à semi-conducteur ayant
une structure multicouche (04) comprenant une arête (20) et une zone (16, 18) d'enlèvement de matériau adjacente à l'arête (20) de chaque côté, dans lequel la structure multicouche (04) est disposée sur un substrat (02) et dans lequel un plan (26) d'expansion de couche est défini par une surface du substrat (02), l'arête (20) a au moins une région active (10) et au moins la région active (10) est limitée spatialement par un passage (22, 24) entre l'arête (20) et les zones (16, 18) d'enlèvement de matériau dans une dimension du plan (26) d'expansion de couche, dans lequel la région active (10) a une structure de couche pour former un laser à cascade interbande, dans lequel, au moins dans les zones (16, 18) d'enlèvement de matériau, une couche isolante (28) et une couche (30) de structure de réseau superposée sont prévues,
dans lequel la couche isolante (28) et la couche (30) de structure de réseau sont disposées dans les zones (16, 18) d'enlèvement de matériau de telle manière que la couche (30) de structure de réseau est disposée au-dessous, mais pas plus de 100 nm au-dessous, d'un bord inférieur de la région active (10), dans lequel la couche (30) de structure de réseau a un métal et est formée par des âmes de réseau qui sont périodiques au moins par sections, dans lequel la couche (30) de structure de réseau a des âmes de réseau en métal séparées et parallèles les unes par rapport aux autres, dans lequel les âmes de réseau de la couche (30) de structure de réseau sont disposées perpendiculairement par rapport à l'orientation de l'arête (20) de la structure multicouche (04) de manière qu'une rétroaction optique avec un rayonnement laser dans la région active (10) est générée.

2. Laser (01) à semi-conducteur selon la revendication 1,
**caractérisé en ce que**
la structure multicouche (04) a au moins une couche (08, 12) de guide d'ondes.

3. Laser (01) à semi-conducteur selon la revendication 1 ou 2,
**caractérisé en ce que**
la structure multicouche (04) a au moins une couche (06, 14) de gaine.

4. Laser (01) à semi-conducteur selon la revendication 3,
**caractérisé en ce que**
perpendiculairement au plan (26) d'expansion de couche, une couche de contact supérieure fortement dopée est adjacente à une couche de gaine (14).

5. Laser (01) à semi-conducteur selon l'une quelconque des revendications 1 à 4,
**caractérisé en ce que**
chaque passage (22, 24) a une extension (23) dans une section orientée vers le substrat (02), dans lequel l'angle entre le passage (22) et le plan (26) d'expansion de couche devient continuellement plus petit vers la zone (16) d'enlèvement de matériau adjacente au passage (22) par l'extension (23).

6. Laser (01) à semi-conducteur selon l'une quelconque des revendications 1 à 5,
**caractérisé en ce que**
les passages (22, 24) entre l'arête (20) et les zones (16, 18) d'enlèvement de matériau sont chacun formés au moins par sections par un flanc (32, 34).

7. Laser (01) à semi-conducteur selon la revendication 6,
**caractérisé en ce que**
les flancs (32, 34) sont formés au moins par sections par un flanc incliné et forment un angle de 10° à 90°, notamment de 70° à 90°, avec le plan (26) d'expansion de couche.

8. Laser (01) à semi-conducteur selon l'une quelconque des revendications 1 à 7,
**caractérisé en ce que**
la couche isolante (28) et/ou la couche (30) de structure de réseau sont disposées au moins partiellement dans la zone des passages (22, 24) et/ou dans la zone des flancs (32, 34).

9. Procédé pour la production d'un laser (01) à semi-conducteur, ledit procédé comprenant les étapes de procédé suivantes :
- appliquer une structure multicouche (04) sur un substrat (02), dans lequel les couches de la structure multicouche (04) s'étendent parallèlement par rapport à un plan (26) d'expansion de couche qui définit une surface du substrat (02) et dans lequel l'application de la structure multicouche (04) comprend au moins la génération d'une région active (10) avec une structure de couche pour former un laser à cascade interbande ;
- enlever du matériau de la structure multicouche (04) dans deux zones (16, 18) d'enlèvement de matériau séparées, dans lequel le matériau est enlevé essentiellement perpendiculairement par rapport au plan (26) d'expansion de couche et, ainsi, une arête (20) est formée qui est séparée de telle manière des zones (16, 18) d'enlèvement de matériau par des passages (22, 24) qu'au moins la région active (10) est limitée spatialement dans une dimension du plan (26) d'expansion de couche par les passages (22, 24)
- générer une couche isolante (28) sur au moins les zones (16, 18) d'enlèvement de matériau
- appliquer une couche (30) de structure de réseau au moins dans la zone des zones (16, 18) d'enlèvement de matériau,
dans lequel l'enlèvement de matériau et l'application de la couche isolante (28) et/ou la couche (30) de structure de réseau sont coordonnés de telle manière que la couche (30) de structure de réseau est disposée au-dessous, mais pas plus de 100 nm au-dessous, d'un bord inférieur de la région active (10), dans lequel un métal est au moins déposé et structuré pour produire la couche de structure de réseau de manière qu'au moins dans les zones de la couche (30) de structure de réseau qui contribuent au couplage avec la lumière laser, des âmes de réseau séparées en métal sont formées, dans lequel les âmes de réseau sont disposées perpendiculairement par rapport à l'expansion de l'arête (20) de la structure multicouche (04) et ont, au moins par sections, une périodicité dans des zones séparées.

10. Procédé selon la revendication 9,
**caractérisé en ce que**
l'application de la structure multicouche (04) comprend l'application d'au moins une couche (08, 12) de guide d'ondes et/ou l'application d'au moins une couche de gaine (06, 14).

11. Procédé selon la revendication 9 ou 10,
**caractérisé en ce**
**qu'**une extension est formée dans une section des passages (22, 24) orientée vers le substrat par l'enlèvement de matériau, dans lequel l'extension est formée de telle manière que l'angle entre le passage (22) et le plan (26) d'expansion de couche devient continuellement plus petit vers la zone (16) d'enlèvement de matériau adjacente au passage.

12. Procédé selon l'une quelconque des revendications 9 à 11, **caractérisé en ce que**
chaque passage (22, 24) entre l'arête (20) et les zones (16, 18) d'enlèvement de matériau est formé au moins par sections sous la forme d'un flanc (32, 34) par l'enlèvement de matériau et, notamment, **en ce que** le matériau est enlevé de telle manière que les flancs (32, 34) sont formés au moins par sections comme flancs inclinés et forment un angle de 10° à 90°, notamment de 70° à 90°, avec le plan (26) d'expansion de couche du substrat (02).

13. Procédé selon l'une quelconque des revendications 9 à 12, **caractérisé en ce que**
la couche isolante (28) et/ou la couche (30) de structure de réseau sont disposées au moins partiellement dans la zone des passages (22, 24) et/ou dans la zone des flancs (32, 34).
